Europäisches Patentamt

European Patent Office

Office européen des brevets

(11) Numéro de publication: **0 208 588 B1**

(12) **FASCICULE DE BREVET EUROPEEN**

(45) Date de publication de fascicule du brevet:
**15.01.92**

(51) Int. Cl.5: **H03K 17/60**, H03K 17/04

(21) Numéro de dépôt: **86401353.7**

(22) Date de dépôt: **20.06.86**

(54) **Alimentation électrique.**

(30) Priorité: **25.06.85 FR 8509652**

(43) Date de publication de la demande:
**14.01.87 Bulletin 87/03**

(45) Mention de la délivrance du brevet:
**15.01.92 Bulletin 92/03**

(84) Etats contractants désignés:
**DE GB IT NL SE**

(56) Documents cités:
EP-A- 0 154 608    DE-A- 2 644 950
FR-A- 2 117 914    US-A- 3 813 561
US-A- 3 959 750    US-A- 4 507 629

ELECTRONICS LETTERS, vol. 18, no. 18, septembre 1982, pages 776,777, Londres, GB; B.L. HART: "Automatic start-up technique for complementary PTAT current generators"

IEEE TRANSACTIONS ON MICROWAVE THEORY AND TECHNIOUES, vol. MTT-22, no. 6, juin 1974, pages 658-674, New York, US; J.F. WHITE: "Diode phase shifters for array antennas"

J. Markus: "Sourcebook of Electronic Circuits", McGraw-Hill Book Company, 1968, page 231, Circuit "Nonstalling Flip-Flop for Capacitive Load"

J. Markus: "Modern Electronic Circuits Reference Manual", McGraw-Hill, 1980, page 1105, Circuit "Touch Buttons"

J.P. Oemichen, Emploi Rationel des Transistors", 5e Edition, Editions Radio, Paris 1980, page 224

(73) Titulaire: **THOMSON-CSF**
**51, Esplanade du Général de Gaulle**
**F-92800 Puteaux(FR)**

(72) Inventeur: **Frappe, Gérard**
**THOMSON-CSF SCPI 19, avenue de Messine**
**F-75008 Paris(FR)**
Inventeur: **Ortalli, Patrice**
**THOMSON-CSF SCPI 19, avenue de Messine**
**F-75008 Paris(FR)**

(74) Mandataire: **Benoit, Monique et al**
**THOMSON-CSF SCPI**
**F-92045 PARIS LA DEFENSE CEDEX 67(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

# Description

La présente invention a principalement pour objet une alimentation électrique, par exemple une alimentation électrique pour dispositif de commutation rapide à diodes PIN.

Les antennes à balayage électronique comportent une ou des sources primaires de rayonnement et un réseau de déphaseurs associé à des sources élémentaires. On utilise fréquemment des déphaseurs comportant des diodes PIN. Le déphasage est obtenu, soit en effectuant une commutation entre des chemins de longueur différente, soit en faisant varier les réactances des diodes PIN, suivant qu'elles sont dans leur état passant ou dans leur état bloqué.

Avec une antenne à balayage électronique, on dirige les faisceaux d'énergie électromagnétique, en formant un plan équiphase perpendiculaire à la direction du faisceau. L'agilité spatiale du faisceau est limitée par le temps nécessaire au changement des déphasages de chaque source élémentaire de l'antenne. Une augmentation de la vitesse de changement de phase des diverses sources élémentaires de l'antenne permet d'effectuer la poursuite d'un nombre plus élevé de cibles.

La transition, dite commutation, entre l'état de non-conduction et l'état de conduction des diodes PIN déphaseuses s'effectue rapidement. Par contre, la commutation inverse, dans le sens de la non-conduction ne s'effectue pas instantanément. De ce fait, avec une source de tension aux bornes des diodes PIN au moment de la commutation, chaque diode PIN commence à se comporter comme un court-circuit où le courant inverse devient important, puis se bloque. A ce moment lorsqu'on inverse la polarité de la tension appliquée à la jonction de chaque diode PIN le courant dans la diode croît rapidement. Ce courant inverse est dû au déplacement des porteurs minoritaires, préalablement stockés pendant la période de conduction directe au niveau de la jonction. La quantité des charges stockées est fonction des caractéristiques de la diode, de la durée de vie des porteurs minoritaires et du courant direct avant la commutation. L'écoulement de ces charges est assuré par des moyens de blocage qui débitent un courant inverse réalisé par élimination des porteurs de charges. Ainsi la rapidité de la commutation est liée à l'intensité du courant débité par les moyens de blocage.

Le livre de J. Markus : "Modern Electronic Circuits Reference Manual", Mc Graw-Hill Book Company, 1980, page 1105, circuit "touch buttons" (cf. Directives C-VI, 8.9) décrit une alimentation électrique comportant une boucle d'amplification incluant une résistance électrique.

Le document Electronics Letters, Vol. 18, n° 12, Septembre 1982, pages 776,777 décrit un circuit de mesure de températures comportant des transistors dans un montage bistable.

Selon l'art connu les moyens de blocage qui délivrent un courant inverse dès que l'on veut établir le blocage des diodes sont constitués d'une source haute tension associée à une résistance élevée. L'alimentation en haute tension est volumineuse et doit débiter un courant important. De ce fait la puissance d'alimentation est considérable, la dissipation thermique est grande. Il en résulte des élévations de température du dispositif de blocage des diodes.

On connait d'après le document "Electronics Letters" du 2 septembre 1982, Vol 18, n° 18, pages 776-777 un générateur de courant tel que décrit dans le préambule de la revendication 1.

L'alimentation électrique selon la présente invention permet d'améliorer la commutation des diodes déphaseuses de leur état passant à leur état bloqué. De plus, l'alimentation selon l'invention permet de réduire les puissances électriques nécessaires à la commutation des diodes déphaseuses. L'alimentation selon l'invention, pour un dispositif de commutation rapide, est du type comportant un premier miroir de courant à une entrée et une sortie de rebouclage et une sortie d'utilisation , et un deuxième miroir de courant comportant une entrée et une sortie, ces deux miroirs étant montés en boucle d'amplification, est caractérisée par le fait que l'entrée du premier miroir est reliée par un commutateur de déclenchement à la sortie du deuxième miroir, que l'entrée du deuxième miroir est reliée à une source de courant d'amorçage, et que la sortie de rebouclage du premier miroir est reliée par un élément limiteur de courant commandé par la tension à la sortie d'utilisation du premiere miroir et agissant après une phase d'amorçage.

L'invention sera mieux comprise au moyen de la description ci-après et des figures annexées données comme des exemples non limitatifs parmi lesquels :

- la figure 1 est un schéma d'un exemple de réalisation de l'invention comportant des composants discrets ;
- la figure 2 est un shéma d'un dispositif selon l'invention réalisé sous forme d'un circuit monolithique ;
- la figure 3 est un schéma général d'un dispositif selon l'invention associé à une diode PIN.

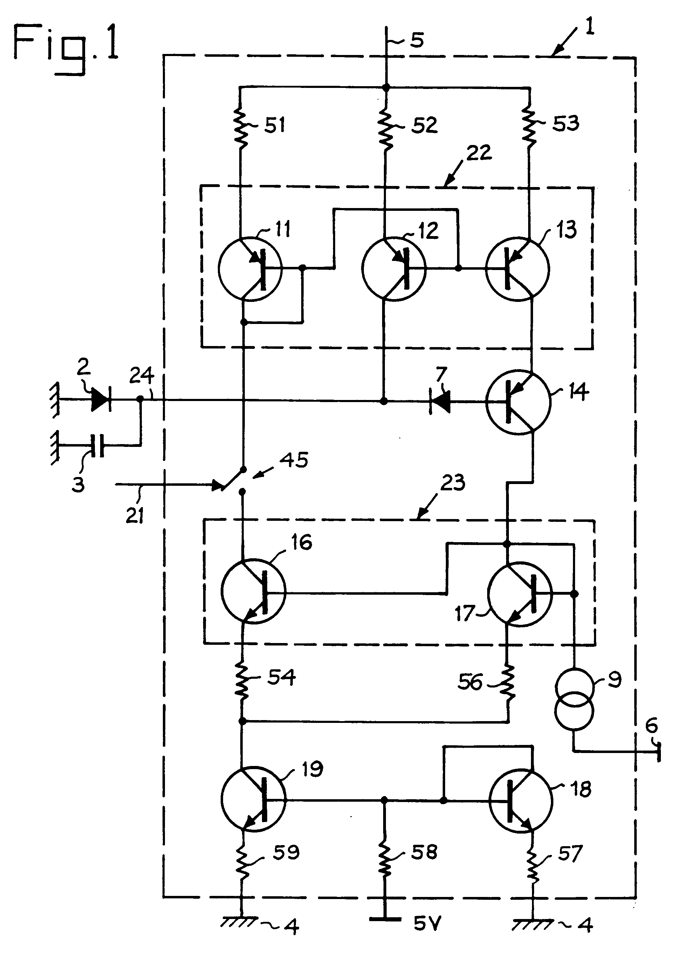

Sur les figures 1 à 3 on a utilisé les mêmes références pour désigner les mêmes éléments.

Sur la figure 1, on peut voir un premier exemple de réalisation du dispositif selon l'invention. L'exemple illustré est adapté à une réalisation comportant des composants électroniques discrets. L'exemple de réalisation illustré sur la figure 1 d'un dispositif d'alimentation 1 en courant électrique de commutation d'une diode PIN 2 comporte quatre transistors PNP 11, 12, 13 et 14, quatre transistors NPN 16, 17, 18 et 19, une diode 7, un générateur de courant 9, huit résistances 51, 52, 53, 54, 56, 57, 58 et 59, un commutateur 45. Le commutateur 45 est par exemple un transistor. La connection 5 du dispositif 1 est alimentée en courant continu, par exemple porté à un potentiel de 40 volts. Les émetteurs de transistors 11, 12 et 13 sont connectés à la sortie 5 respectivement par les résistances 51, 52 et 53. Le collecteur du transistor 11 est connecté à sa base. Les bases des transistors 11, 12 et 13 sont reliées électriquement. Le collecteur du transistor 13 est relié à l'émetteur du transistor 14. La base du transistor 14 est reliée au collecteur du transistor 12 à travers la diode 7. Le collecteur du transistor 12 est d'autre part relié à la sortie 24 du dispositif d'alimentation 1. Le collecteur du transistor 11 est connecté au collecteur du transistor 16 à travers un commutateur 45. Le collecteur du transistor 14 est relié à la base du transistor 16 et au collecteur et à la base du transistor 17. La base du transistor 17 est reliée à un générateur de courant 9 alimenté par une entrée 6 portée par exemple à une tension de 5 volts. Les émetteurs des transistors 16 et 17 sont reliés au collecteur du transistor 19 respectivement par les résistances 54 et 56. Les bases des transistors 19 et 18 sont reliées. Le collecteur et la base du transistor 18 sont connectés. L'émetteur du transistor 19 est mis à la masse 4 au travers d'une résistance 59. Les bases des transistors 18 et 19 sont reliées à une basse tension par exemple 5V au travers d'une résistance 58, l'émetteur du transistor 18 est relié à la masse 4 au travers d'une résistance 57. La diode de commutation PIN 2 est alimentée par la sortie 24 du dispositif 1. Avantageusement le découplage de la diode PIN 2 du champ hyperfréquence est assuré par un condensateur 3 monté en parallèle. Les transistors 11, 12 et 13 forment un premier miroir de courant 22. Les transistors 16 et 17 forment un second miroir de courant 23.

Au démarrage de la commutation le commutateur 45 est fermé. A ce moment là, le double miroir de courant 22 et 23 fonctionne en boucles amplificatrices. Le courant dans la boucle monte de façon exponentielle. Et quasi instantanément on dispose sur le collecteur du transistor 12 du courant important nécessaire à la commutation de la diode PIN 2. Le courant maximal est limité par le couple de transistors 19 et 18. Le générateur de courant 9 assure l'amorçage de la boucle de courant. L'arrivée du transistor 12 à un état proche de la saturation provoque le blocage du transistor 14.

Il en est de même des transistors 16 et 17. Soit R52, R53, R54, R56, respectivement les valeurs des résistances 52, 53, 54 et 56. Le gain G de la boucle d'amplification est égal à :

$$G = \frac{R51}{R53} \times \frac{R56}{R54}$$

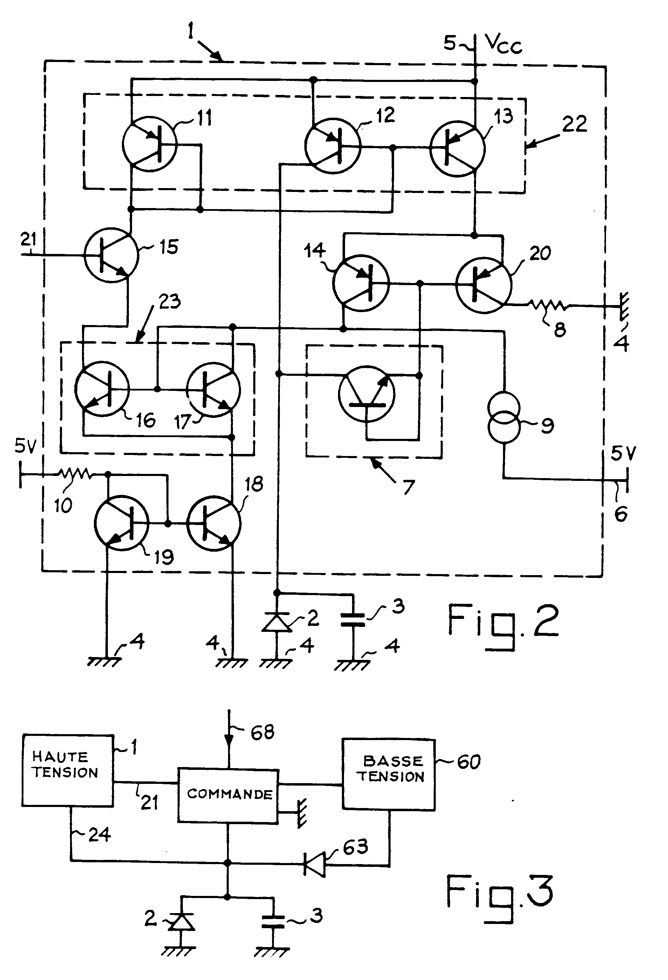

Le dispositif illustré sur la figure 2 comporte cinq transistors PNP 11, 12, 13, 14 et 20, cinq transistors NPN 15, 16, 17, 18 et 19, une diode 7, un générateur de courant 9, deux résistances 8 et 10. Dans une variante de réalisation, la diode 7 est remplacée par un transistor dont la base et l'émetteur sont reliés.

Sur la figure 2, on peut voir un schéma d'un exemple du dispositif selon l'invention particulièrement bien adapté à la réalisation sous forme de circuit monolithique par exemple en technologie bipolaire. Le dispositif d'alimentation 1 comporte une entrée d'alimentation 5 en courant continu, portée par exemple à 40 volts. L'entrée 5 est reliée aux émetteurs de trois transistors 11, 12 et 13. La base du transistor 11 est relié à son collecteur. Les bases des transistors 12 et 13 sont reliées, le collecteur du transistor 13 est relié aux émetteurs des transistors 14 et 20. Le collecteur du transistor 12 est relié d'une part à travers une diode 7 aux bases des transistors 14 et 20. D'autre part, le collecteur du transistor 12 est relié à la diode PIN 2 et au condensateur 3 placé en parallèle. La base du transistor 11 est reliée au collecteur du transistor 15. Le transistor 15 est relié à une entrée 21 de commande. Le collecteur du transistor 20 est relié par une résistance 8 à la masse 4. Le collecteur du transistor 14 est relié à un générateur de courant 9, au collecteur du transistor 17 et aux bases des transistors 17 et 16. L'émetteur du transistor 15 est relié au collecteur du transistor 16. Le générateur de courant 9 est relié à une entrée 6 d'alimentation en courant continu par exemple portée à une tension de 5 volts. Les émetteurs des transistors 16 et 17 sont reliés au collecteur du transistor 18. Les bases des transistors 18 et 19 sont reliées au travers d'une résistance 10 à une entrée d'alimentation en courant continu par exemple sur une tension de 5 volts. La base du transistor 19 est reliée à son collecteur. Les émetteurs des transistors 18 et 19 sont reliés à la masse 4.

Le dispositif illustré sur la figure 2 comporte deux miroirs de courant 22 et 23. Leur interconnexion permet d'obtenir une boucle d'amplification qui au démarrage présente une croissance exponentielle du courant disponible à la sortie 24 du dispositif 1. Le courant maximal débité est limité par le couple des transistors 18 et 19. L'arrivée du transistor 12 près de sa zone de saturation provoque le blocage du transistor 14. Le générateur de courant 9 assure l'amorçage de la boucle d'amplification. Le démarrage est obtenu par une commande sur l'entrée 21 du transistor 15. Le transistor 20 ainsi que la résistance 8 permettent de contrôler le bon fonctionnement de la diode PIN 2. Si la diode 2 présente un courant de fuite il est impossible de l'amener à la tension de blocage par exemple 40 volts. La détection d'une diode présentant une fuite de courant peut se faire par une mesure de tension aux bornes de la résistance 8.

Le dispositif 1 illustré sur la figure 2 est particulièrement bien adapté à la réalisation en circuit intégré. La réalisation du dispositif monolithique est rendue difficile par l'apparition de transistors parasites augmentant la consommation desdits dispositifs. Le substrat d'un circuit monolothique joue le rôle d'un collecteur branché en parallèle sur un transistor PNP désiré.

Le dispositif selon l'invention permet de limiter le courant parasite. Notamment l'utilisation d'un courant I délivré par le générateur 9 faible permet de minimiser la consommation électrique au repos du dispositif. Dans un exemple du dispositif selon l'invention le courant I débité par le générateur de courant 9 est égal à 10 µA.

Sur la figure 3, on peut voir un dispositif d'alimentation d'une diode PIN 2 de commutation mettant en oeuvre le dispositif selon l'invention. Comme on l'a vu la commutation d'une diode PIN de leur état passant à leur état bloqué nécessite l'élimination de porteurs minoritaires suivie de l'élévation de la tension à la jonction de la diode à la tension de blocage. L'élimination de porteurs minoritaires exige un courant important tandis que le blocage de la diode nécessite une tension plus élevée par exemple 40 volts. Le dispositif illustré sur la figure 3 comporte un générateur basse tension 60, un circuit de commande 61, un générateur de haute tension 1, une diode de blocage 63. Le générateur haute tension 1 est semblable à un dispositif illustré sur la figure 1 ou 2. Sur la figure 3 sont également illustrées la diode PIN 2 à commuter montée en parallèle avec un condensateur 3, ainsi que l'arrivée du signal de commande 68 connecté au circuit de commande 61. Le circuit de commande 61 est connecté au générateur basse tension 60 ainsi qu'à la porte 21 du générateur haute tension. La sortie du générateur basse tension est reliée à la diode 2 et au condensateur 3 à travers une diode 63, le générateur haute tension 1 est relié à la diode 2 et au condensateur 3. Le circuit de commande est relié à l'entrée de la diode 2 d'une part et à la masse d'autre part. Le circuit de commande 61 comporte des moyens de mesure de tension ainsi que des comparateurs.

Dans un premier temps le générateur basse tension 60 débite un courant important assurant l'élimination des porteurs minoritaires. Quand la tension aux bornes de la diode 2 s'élève, une fois les porteurs minoritaires éliminés, le circuit de commande 61 active le circuit d'alimentation 1 délivrant une haute tension nécessaire au blocage de la diode. La haute tension polarise la diode 63 isolant le générateur basse tension 60 du générateur haute tension 1.

L'utilisation d'un générateur basse tension permet d'utiliser le générateur haute tension pendant un temps plus réduit. Ainsi il est particulièrement avantageux de réduire la consommation au repos du circuit du générateur haute tension 1.

Il est bien entendu que le dispositif de la figure 3 est associé à chaque diode PIN de chaque déphaseur de l'antenne.

L'invention s'applique principalement aux radars comportant des antennes à balayage électronique.

**Revendications**

1. Alimentation électrique pour un dispositif de commutation rapide comportant un premier miroir de courant (22) à une entrée (collecteur de 11) et une sortie de rebouclage (collecteur de 13) et une sortie d'utilisation (collecteur de 12), et un deuxième miroir de courant (23) comportant une entrée (collecteur de 17) et une sortie (collecteur de 16), ces deux miroirs étant montés en boucle d'amplification, caractérisée par le fait que l'entrée du premier miroir est reliée par un commutateur de déclenchement (45) à la sortie du deuxième miroir, que l'entrée du deuxième miroir est reliée à une source de courant d'amorçage (9), et que la sortie de rebouclage du premier miroir est reliée par un élément limiteur de courant (14) commandé par la tension à la sortie d'utilisation du premier miroir et agissant après une phase d'amorçage.

2. Alimentation selon la revendication 1, caractérisée par le fait que le premier miroir de courant comporte trois transistors, reliés par une de leurs électrodes à une source de haute tension (Vcc), et dont le premier (11) est relié au commutateur (15, 45) le second (12) au dispositif de commutation rapide (2), et le troisième (13) au deuxième générateur de courant (9).

3. Alimentation selon la revendication 1 ou 2, caractérisée par le fait que le second miroir de courant comporte deux transistors (16, 17), dont le premier est relié au commutateur (15, 45) et à une source basse tension (5V), et dont le second est relié au premier miroir de courant (22), à la source basse tension et au second générateur de courant.

4. Alimentation selon l'une des revendications précédentes, caractérisée par le fait que le second miroir de courant (23) est relié à un circuit de limitation de courant (18, 19).

5. Alimentation selon l'une des revendications précédentes, réalisée en circuit intégré, caractérisée par le fait qu'elle comporte un circuit de détection de courant de fuite du dispositif de commutation rapide.

6. Alimentation selon la revendication 5, caractérisée par le fait que le circuit de détection comporte un transistor (20) et une résistance (8) disposés en série avec le premier miroir de courant.

7. Alimentation selon l'une des revendications précédentes, caractérisée par le fait que le dispositif de commutation rapide est une diode PIN.

8. Alimentation selon la revendication 7, caractérisée par le fait que la diode PIN fait partie d'un déphaseur pour une antenne à balayage électronique.

9. Radar, caractérisé par le fait qu'il comporte une antenne à balayage électronique à déphaseurs à diodes PIN alimentées par une alimentation selon l'une des revendications 1 à 8.

## Claims

1. An electrical power supply for a high-speed switching device comprising a first current mirror (22) having an input (collector of 11) and a feedback output (collector of 13) and a user output (collector of 12) and a second current mirror (23) comprising an input (collector of 17) and an output (collector of 16), said two mirrors being arranged in an amplification loop, characterized in that the input of the first mirror is connected by a triggering switch (45) with the output of the second mirror, in that the input of the second mirror is connected with a source of starting current (9) and in that the feedback output of the first mirror is connected by a current limiting element (14) controlled by the voltage with the user output of the first mirror and acting after a starting phase.

2. The power supply as claimed in claim 1, characterized in that the first current mirror comprises three transistors, connected by one of their electrodes with a source of high voltage (Vcc), and of which the first one (11) is connected with the switch (15 and 45), the second is connected with the high-speed switching device (2) and the third one (13) is connected with the second current generator (9).

3. The power supply as claimed in claim 1 or in claim 2, characterized in that the second current mirror comprises two transistors (16 and 17), of which the first one is connected with the switch (15 and 45) and with a source (5V) of low voltage and of which the second one is connected with the first current mirror (22), with the source of low voltage and with the second current generator.

4. The power supply as claimed in any one of the preceding claims, characterized in that the second current mirror (23) is connected with a current limiting circuit (18 and 19).

5. The power supply as claimed in any one of the preceding claims in the form of an integrated circuit, characterized in that it comprises a circuit for detecting leak current from the high-speed switching device.

6. The power supply as claimed in claim 5, characterized in that the detecting circuit comprises a transistor (20) and a resistor (8) placed in series with the first current mirror.

7. The power supply as claimed in any one of the preceding claims, characterized in that the high-speed switching device is a PIN diode.

8. The power supply as claimed in claim 7, characterized in that the PIN diode forms part of a phase modifier for an electronic sweep antenna.

9. A radar installation, characterized in that it comprises an electronic sweep antenna with PIN diode phase modifiers supplied by a power supply as claimed in any one of the preceding claims 1 through 8.

## Patentansprüche

1. Elektrische Stromversorgung für eine schnelle Schalteinrichtung, mit einem ersten Stromspiegel (22), der einen Eingang (Kollektor von 11), einen Rückleitungsausgang (Kollektor von 13) und einen Nutzausgang (Kollektor von 12) besitzt, und einem zweiten Stromspiegel (23), der einen Eingang (Kollektor von 17) und einen Ausgang (Kollektor von 16) besitzt, wobei diese zwei Spiegel als Verstärkungsschleife angeordnet sind, dadurch gekennzeichnet, daß der Eingang des ersten Spiegels über einen Auskoppelungsschalter (45) mit dem Ausgang des zweiten Spiegels verbunden ist, daß der Eingang des zweiten Spiegels mit einer Ansteuerstromquelle (9) verbunden ist und daß der Rückleitungsausgang des ersten Spiegels mit einem von der Spannung am Nutzausgang des ersten Spiegels gesteuerten Strombegrenzerelement (14) verbunden ist und nach einer Ansteuerphase wirksam ist.

2. Stromversorgung gemäß Anspruch 1, dadurch gekennzeichnet, daß der erste Stromspiegel drei Transistoren umfaßt, die mit einer ihrer Elektroden mit einer Hochspannungsquelle (Vcc) verbunden sind, wobei der erste (11) mit dem Schalter (15, 45), der zweite (12) mit der schnellen Schalteinrichtung (2) und der dritte (13) mit dem zweiten Stromgenerator (9) verbunden ist.

3. Stromversorgung gemäß Anspruch 1 oder 2, dadurch gekennzeichnet, daß der zweite Stromspiegel zwei Transistoren (16, 17) umfaßt, wobei der erste mit dem Schalter (15, 45) und mit einer Niederspannungsquelle (5V) und der zweite mit dem ersten Stromspiegel (22), mit der Niederspannungsquelle und mit dem zweiten Stromgenerator verbunden ist.

4. Stromversorgung gemäß einem der vorangehenden Ansprüche, dadurch gekennzeichnet, daß der zweite Stromspiegel (23) mit einer Strombegrenzerschaltung (18, 19) verbunden ist.

5. Stromversorgung gemäß einem der vorangehenden Ansprüche, die als integrierte Schaltung verwirklicht ist, dadurch gekennzeichnet, daß sie eine Erfassungsschaltung für den Leckstrom der schnellen Schalteinrichtung umfaßt.

6. Stromversorgung gemäß Anspruch 5, dadurch gekennzeichnet, daß die Erfassungsschaltung einen Transistor (20) und einen Widerstand (8) umfaßt, die mit dem ersten Stromspiegel in Reihe geschaltet sind.

7. Stromversorgung gemäß einem der vorangehenden Ansprüche, dadurch gekennzeichnet, daß die schnelle Schalteinrichtung eine PIN-Diode ist.

8. Stromversorgung gemäß Anspruch 7, dadurch gekennzeichnet, daß die PIN-Diode einen Teil eines Phasenschiebers für eine Antenne mit elektronischer Abtastung bildet.

9. Radar, dadurch gekennzeichnet, daß er eine Antenne mit elektronischer Abtastung mit PIN-Dioden-Phasenschiebern, die von einer Stromversorgung gemäß einem der Ansprüche 1 bis 8 versorgt werden, aufweist.

Fig.1

Fig.2

Fig.3